# EUROPEAN PATENT APPLICATION

(11) **EP 2 362 541 A1**
(43) Date of publication of application: **31.08.2011**
(21) Application number: 10360012.8
(22) Date of filing: 25.02.2010
(51) Int. Cl.: H03F 1/02, H03F 3/60, H03F 3/72

(54) **Parallel amplifier**

(71) Applicant: Alcatel Lucent, 75008 Paris (FR)
(72) Inventor: Grebennikov, Andrei, Castleknock, Dublin 15 (IE)
(74) Representative: Leppard, Andrew John

(57) **Abstract**

A parallel amplifier (100A) comprises: a plurality of amplifier modules (10A,10B,10C,10D) each operable to receive an input signal (RFin), each amplifier module (10A,10B,10C,10D) being switchable between an amplifying state and a non-amplifying state to vary a power of an amplified output signal provided by said parallel amplifier (100A), each amplifier module (10A,10B,10C,10D)comprising: an amplifier and an offset line arrangement (20A,20B,20C,20D), said offset line arrangement (20A,20B,20C,20D) being operable to compensate for an output reactance of said amplifier in said non-amplifying state. By counteracting the output reactance of the amplifier with the offset line arrangement, the output reactance may be substantially eliminated to enable the output of the amplifier module to achieve a desired impedance. Accordingly, the extent of any leakage into the amplifier module may be reduced, as are any changes to signals produced by the parallel amplifier when the amplifier module is in the nonconducting state. In this way, it can be seen that the efficiency of the parallel amplifier (100A) may be increased.

## Description

### FIELD OF THE INVENTION

The present invention relates to a parallel amplifier.

### BACKGROUND

Parallel amplifiers are known. In most communications systems, it is required that power amplifiers used to amplify signals for transmission are able to operate with high efficiency and high linearity simultaneously. However, there is typically a trade-off between efficiency and linearity, with improvements in one generally coming at the expense of the other. Many wireless telecommunications systems, such as Global System for Mobile Communications (GSM)/Enhanced Data Rates for GSM Evolution (EDGE), Code division multiple access (CDMA 2000) or Wideband Code Division Multiple Access (WCDMA) require that the power amplifier is able to deliver a wide range of output powers. Accordingly, the power amplifiers are typically designed to provide the highest power output level with the maximum available efficiency. These amplifiers, which may be provided in base stations, tend to operate less efficiently at lower power output levels since they consume comparatively high amounts of direct current (DC) power at these lower power output levels. Designing a base station power amplifier which has a high efficiency and high linearity, not only at the maximum output power, but also at lower output power levels, typically ranging from -6DB and less, without using additional linearisation schemes is challenging. A Doherty power amplifier is one such parallel amplifier in which a carrier amplifier is provided in parallel with a peaking amplifier. The input signal is split and provided to each of the two amplifiers. Both of the amplifiers then amplify the signal, which is then combined to create an output signal. When operating at the maximum power output, both amplifiers are utilised. However, when the total output power is typically less than 6dB from the maximum output power, the peaking amplifier is turned off. This arrangement provides higher efficiency compared to conventional class AB solutions since the carrier amplifier is biased in class AB, but the peaking amplifier is biased in class C and is turned off when the total output power is typically less than 6dB from the maximum output power level.

Although these arrangements provide for higher efficiency at other than the maximum output power level, such parallel amplifiers exhibit undesirable characteristics.

Accordingly, it is desired to provide an improved parallel amplifier.

### SUMMARY

According to a first aspect, there is provided a parallel amplifier, comprising: a plurality of amplifier modules each operable to receive an input signal, each amplifier module being switchable between an amplifying state and a non-amplifying state to vary a power of an amplified output signal provided by the parallel amplifier, each amplifier module comprising: an amplifier and an offset line arrangement, the offset line arrangement being operable to compensate for an output reactance of the amplifier in the non-amplifying state.

The first aspect recognises that a problem with existing parallel amplifiers is that when an amplifying module is in a non-amplifying state (i.e. it is not being utilised to amplify the input signal, such as would occur when the amplifier module is biased to be switched 'off' and so it is not operated in the amplifying region of its transfer characteristics), the output impedance of that amplifier module presented to other components of the parallel amplifier may not be as expected. This means that signals from other modules or component in the parallel amplifier may leak into or have their characteristics altered by the amplifier module, which reduces the overall efficiency of the parallel amplifier. Accordingly, each amplifier module may comprise an amplifier and an offset line arrangement. The offset line arrangement may be configured to compensate for, or cancel out, the output reactance of the amplifier when operating in the non-amplifying state. By counteracting the output reactance of the amplifier with the offset line arrangement, the output reactance may be substantially eliminated to enable the output of the amplifier module to achieve a desired impedance. Accordingly, the extent of any leakage into the amplifier module may be reduced, as are any changes to signals produced by the parallel amplifier when the amplifier module is in the non-conducting state. In this way, it can be seen that the efficiency of the parallel amplifier may be increased.

In one embodiment, parasitic components of the amplifier cause the output reactance and the offset line arrangement is operable to substantially cancel the output reactance in the non-amplifying state. Accordingly, the output impedance of the amplifier module presented to other components of the parallel amplifier may not be effectively infinite (i.e. may not present an open circuit) due to parasitic components within the amplifier module. For example, the amplifier module may utilise an amplifier which has capacitive elements and/or inductive elements which may present an output reactance, which causes the output impedance of the amplifier module to deviate from being effectively an open circuit or a substantially infinite output impedance. The arrangement of the offset line may enable the effects of those parasitic components to be compensated for to provide an effective infinite output impedance.

In one embodiment, the offset line arrangement presents a substantially infinite impedance at an output of the amplifier module in the non-amplifying state. The output impedance of the amplifier module presented to other components of the parallel amplifier may not be effectively infinite (i.e. may not present an open circuit). This means that signals from other modules or component in the parallel amplifier may leak into or have their characteristics altered by the amplifier module, which reduces the overall efficiency of the parallel amplifier. By counteracting the output reactance of the amplifier with the offset line arrangement, the output reactance can be substantially eliminated to enable the output of the amplifier module to achieve an effective infinite impedance, thereby presenting an open circuit to other components of the parallel amplifier. Accordingly, the extent of any leakage into the amplifier module may be reduced, as are any changes to signals produced by the parallel amplifier when the amplifier module is in the non-conducting state. In this way, it can be seen that the efficiency of the parallel amplifier may be increased.

In one embodiment, the parallel amplifier comprises: amplifier module control logic operable to switch at least one of the plurality of amplifier modules to the non-amplifying state in dependence on an amplitude of the input signal. Accordingly, one or more of the amplifier modules may be switched to a non-amplifying state as the amplitude of the input signal varies. Conversely, one or more of the amplifiers may be switched to an amplifying state as the amplitude of the input signal varies.

In one embodiment, the plurality of amplifier modules are arranged in pairs and the amplifier module control logic is operable to switch one of each pair of amplifier modules to the non-amplifying state when the amplitude of the input signal fails to achieve a predetermined threshold level. Accordingly, the amplifier modules may be paired and, when the amplitude of the input signal falls below the threshold level, one amplifier module in each pair may be switched off. It will be appreciated that a Doherty amplifier is an example of such a paired arrangement. In one embodiment, the threshold may be around 6dB from the maximum output level.

In one embodiment, the plurality of amplifier modules are arranged in pairs and the amplifier module control logic is operable to switch all except one amplifier module to the non-amplifying state when the amplitude of the input signal fails to achieve a predetermined threshold level. Accordingly, when the threshold level is not achieved, only one of the power amplifiers may remain on. This arrangement is particularly beneficial in a dual Doherty architecture and provides high efficiency at very low power levels since three of the four amplifier modules can be switched off thereby presenting a high impedance at the couplings of the switched off amplifier modules with the remaining switched on amplifier module so that the remaining switched on amplifier module operates as a conventional amplifier in, for example, a fifty ohm or other characteristic impedance environment, thereby providing an efficient and linear operation at lower output power levels.

In one embodiment, the amplifier module control logic is operable to apply a bias adjustment to amplifier modules in the non-amplifying state to prevent those amplifier modules from providing an amplified signal. Accordingly, the amplifier modules may have their biasing adjusted to ensure that the amplifying modules remain in the non-amplifying state and provide no output signal.

In one embodiment, the amplifier module control logic is operable to apply the bias adjustment to amplifier modules in the non-amplifying state to prevent those amplifier modules from providing the amplified signal when the input signal has an amplitude at or below the predetermined threshold level. Accordingly, the amplifier modules may have their biasing adjusted to ensure that the amplifying modules remain in the non-amplifying state whilst the amplitude of the input signal remains below a predetermined threshold. For example, the bias of the amplifier module may be changed such that modulation of the input voltage below the threshold may cause no output voltage to be provided by the amplifier module. This may be achieved by, for example, applying a direct current (DC) offset to the input voltage when that input voltage remains below the threshold level. This helps to ensure that the amplifier module does not enter the active part of its transfer characteristics and ensures that no output is provided from the amplifier module when the input signal is below the threshold value.

In one embodiment, the amplifier module control logic is operable to reduce the bias adjustment when the input signal has an amplitude at or above the predetermined threshold level. Accordingly, as the input signal exceeds the threshold value, the amount of bias applied may be reduced. This enables the amplifier module to operate more efficiently when amplifying signals exceeding the threshold value.

In one embodiment, the amplifier module control logic is operable to remove the bias adjustment when the input signal has a maximum amplitude. Accordingly, no bias adjustment, such as a DC offset, may be applied to the input signal when the input signal reaches its maximum level. This helps to ensure that the amplifier module operates most efficiently when the input signal is at is highest level.

In one embodiment, the parallel amplifier comprises: an output network operable to combine amplified signals output by amplifier modules, the output network comprising a plurality of quarter-wave transmission lines each operable to receive an amplified signal output by one of the plurality of amplifier modules, the plurality of quarter-wave transmission lines being arranged in parallel with an output to provide the amplified output signal. Accordingly, the output network may merge the amplified signals provided by the amplifier modules to generate the amplified output signal. The network which combines these signals may be assembled from quarter wave transmission lines. It will be appreciated that the use of such transmission lines, rather than a traditional coaxial cable, enables an integrated circuit implementation, either hybrid or monolithic, which would not normally be possible when using coaxial cable.

In one embodiment, the parallel amplifier comprises: an output network operable to combine amplified signals output by pairs of amplifier modules, the output network comprising a plurality of quarter-wave transmission lines each operable to receive an amplified signal output by one of the pairs of amplifier modules, the plurality of quarter-wave transmission lines being arranged in parallel with an output to provide the amplified output signal.

In one embodiment, the parallel amplifier comprises: an input network operable to distribute the input signal to each of the plurality of amplifier modules, the input network comprising a quadrature coupler arrangement. The use of quadrature couplers to effectively split and distribute the input signal is a particularly efficient mechanism for feeding the different amplifier modules. Such quadrature couplers also conveniently provide a 90° phase shift between their outputs which is particularly convenient for Doherty amplifier arrangements which require a 90° phase shift of input signal between amplifiers in each pair.

In one embodiment, quarter wave transmission lines may be provided either within the input or the output network in order to provide any required 90° phase shifts. It will be appreciated that the use of quarter wavelength transmission lines and quadrature couplers also make it possible to provide an integrated circuit implementation, either hybrid or monolithic, which would not be possible with a conventional coaxial input network.

Further particular and preferred aspects are set out in the accompanying independent and dependent claims. Features of the dependent claims may be combined with features of the independent claims as appropriate, and in combinations other than those explicitly set out in the claims.

### BRIEF DESCRIPTION OF THE DRAWINGS

Embodiments of the present invention will now be described further, with reference to the accompanying drawings, in which:
Figure 1 an example of part of an amplifier module;
Figure 2 illustrates a dual Doherty amplifier according to one embodiment;
Figure 3 illustrates a dual Doherty amplifier according to one embodiment;
Figure 4 illustrates a dual Doherty amplifier according to one embodiment; and
Figures 5A and 5B illustrate operation of power amplifiers according to one embodiment.

### DESCRIPTION OF THE EMBODIMENTS

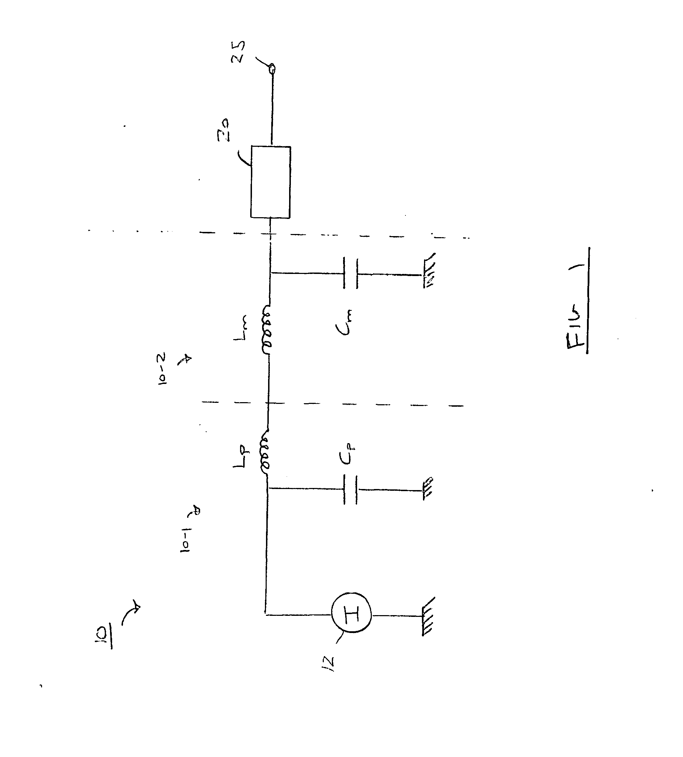

Before discussing the amplifier arrangements in detail, an example of part of an amplifier module is illustrated in Figure 1. A power amplifier 10 comprises an amplifier portion 10-1 and a matching circuit 10-2. The amplifier portion 10-1 receives a signal to be amplified and is represented as a current source 12 coupled with parasitic capacitance Cp and inductance L_{P}. These parasitic components of the power amplifier 10 affect the properties of the power amplifier 10. Accordingly, a matching circuit 10-2 is provided which comprises a matching inductor L_{M} and a matching capacitor C_{M} which attempt to compensate for the properties of the power amplifier 10 caused by the parasitic components. Coupled with the power amplifier 10 is an offset line 20. The offset line 20 is arranged to present a high impedance to the output 25 when the power amplifier 10 is switched off (i.e. is in a non-amplifying mode or state). This offset line is selected to compensate for the effect of the parasitic components of the amplifier 10-1 and the matching circuit 10-2 when the power amplifier 10 is switched off. That is to say that the offset line 20 has characteristics selected to cancel out the reactive components presented at the output of the power amplifier 10 when in the non-amplifying state and to present a desired real impedance. As mentioned above, providing a high impedance improves the efficiency of a parallel amplifier arrangement using a plurality of such amplifier modules since this deters signals from leaking into the amplifier module when switched off. As mentioned above, the signal input to the amplifier module, which is typically a microwave frequency signal, is not shown but is instead represented by the current source 12.

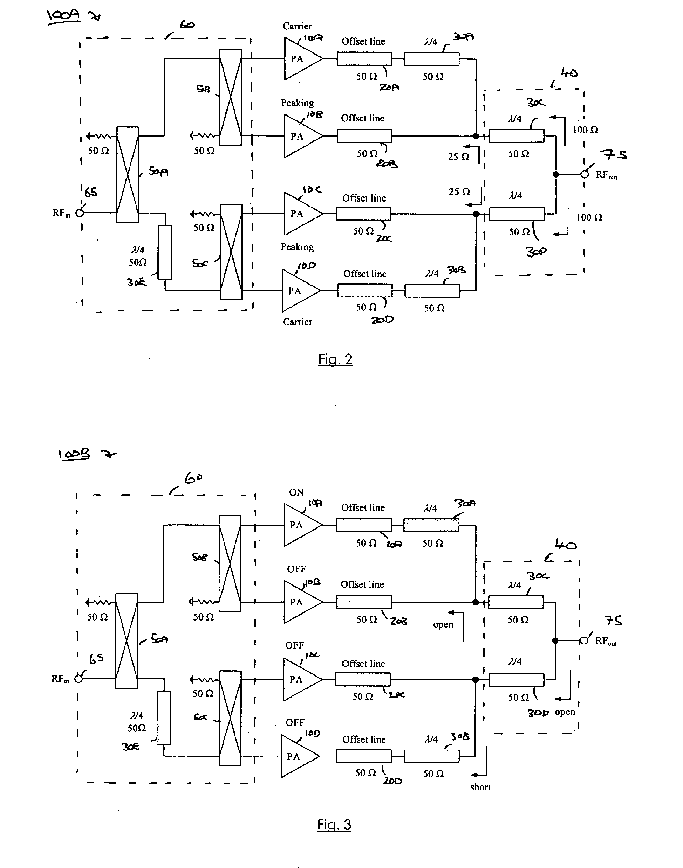

Figure 2 illustrates a dual Doherty amplifier, generally, 100A, according to one embodiment. In this embodiment, two pairs of amplifier modules are provided. The first pair comprises the carrier power amplifier 10A and the peaking power amplifier 10B. The second pair comprises the carrier power amplifier 10D and the peaking power amplifier 10C.

Control circuitry (not shown) switches all of the power amplifiers on when operating at maximum output power. However, when operating below a pre-determined threshold level (typically at around -6dB or less of the maximum level), the control circuitry operates to switch of the peaking power amplifiers 10A, 10C. Coupled with each power amplifier is a corresponding offset line 20A to 20D. These offset lines 20A to 20D compensate for characteristics of the corresponding power amplifiers 10A to 10D to present an open circuit at their outputs when the corresponding power amplifier 10A to 10D is switched off. These offset lines 20A to 20D may be provided in a variety of ways such as, for example, transmission lines, lumped elements, and the like.

An input signal RF_{IN} to be amplified is provided at an input 65 of an input network 60. The input network 60 receives the input signal RF_{IN}, performs any necessary phase shifts and provides this to the inputs of each of the power amplifiers 10A to 10D. The input network 60 comprises an arrangement of quadrature couplers 50A to 50C. A first quadrature coupler 50A receives the input signal RF_{IN} and distributes this signal to two other quadrature couplers 50B and 50C. It will be appreciated that the two outputs of the quadrature coupler will be 90° out of phase. Accordingly, one of the outputs from the quadrature coupler 50A is provided to a quarter wave transmission line 30E which applies a 90° phase shift in order that the signal input to both quadrature coupler 50B and 50C are in phase. The quadrature coupler 50b has two outputs, one of which is coupled to the carrier power amplifier 10A and the other, which is 90° out of phase, to the peaking amplifier 10B. Likewise, the quadrature coupler 50C has one output coupled to the carrier amplifier 10D and another output, which is 90° out of phase, coupled to the peaking amplifier 10C. Accordingly, it can be seen that the input network 60 operates as follows. The input signal RF_{IN} is provided to the input 65 and is split so that the signal provided to each carrier amplifier in each pair is in phase with the input signal RF_{IN} and the signal provided to each peaking amplifier in each pair is phase shifted by 90° compared to the input signal RF_{IN}. Of course, it will be appreciated that the input network 60 may be extended to provide for more than two pairs of power amplifiers. Since the signal provided to the peaking amplifiers 10B and 10C are 90° out of phase, a quarter wavelength transmission strip 30A and 30B is provided on the output path of the carrier amplifiers 10A and 10D to bring the signals provided by the carrier amplifiers 10A and 10D into phase with that output by the peaking amplifiers 10B and 10C.

The outputs of the carrier power amplifier and peaking amp power amplifier pair 10A, 10B; 10C, 10D are then combined and fed into an output network 40. The combined output of each pair is input into corresponding a quarter wavelength transmission strip 30C; 30D and the outputs of each of these quarter wavelength transmission strips 30C, 30D are combined to provide an output signal RF_{OUT} at an output 75.

Accordingly, when each of the power amplifiers 10A to 10D are switched on, the input signal RF_{IN} is distributed to each of the power amplifiers 10A and 10D, which amplify the signal, the phases are corrected and the amplified output signal RF_{OUT} is provided at the output 75. Because the offset lines 20A to 20D and the quarter wave transmission lines 30A to 30E all share the same characteristic impedance, impedance matching occurs.

However, when the peaking amplifiers 10B and 10C are switched off, they present an substantially infinite impedance due to the presence of the offset lines 20B and 20C, which means that the output of the carrier amplifiers 20A and 20D each present a 25 ohm impedance, which is transformed to 100 ohms by the quarter wave transmissions lines 30C and 30D in the output network 40. The parallel arrangement of these two 100 ohm output impedances results in the required, for example, 50 ohm output at the output 75.

Figure 3 illustrates a dual Doherty amplifier, generally 100B, similar to that shown in Figure 2, but operated by control circuitry (not shown) in a manner which provides particularly high efficiency at very low power levels. In this arrangement, the control circuitry is operable to switch off three of the four power amplifiers when the amplitude of the input signal RF_{IN} is below a pre-determined threshold. In particular, the control circuitry operates to switch off the power amplifiers 10B, 10C and 10D when below this predetermined threshold, such as -6dB below the maximum level.

When operating in this arrangement, the output presented by the offset line 20D is open circuit, which means that the quarter wave transmission line 30B presents a short circuit; the quarter wave transmission line 30D, therefore, presents an open circuit to the output 75. The offset line 20B also presents an open circuit. Therefore, the remaining active power amplifier 10A operates as a conventional power amplifier in a, for example, 50 ohm environment, providing and efficient and linear operation at low power levels.

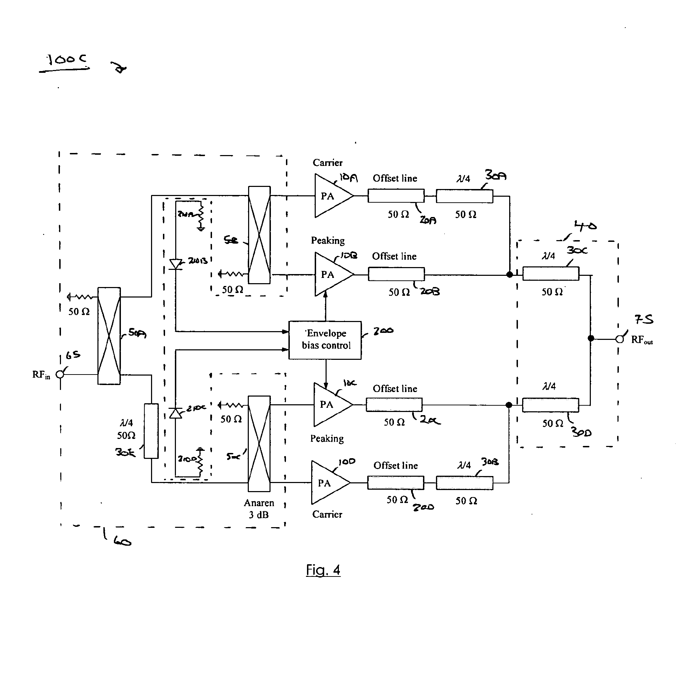

Figure 4 illustrates a dual Doherty amplifier, generally 100C, similar to that described in Figures 2 and 3 above, but with the addition of envelope bias control logic 200 as part of the control circuitry for the power amplifiers 10A o 10D. The envelope bias control logic 200 is, in this example, coupled with the peaking amplifiers 10B, 10C. The envelope bias control logic 200 is fed by a sensing network 210A to 210D which is part of the control circuitry and which senses the amplitude of the input signal RF_{IN}.

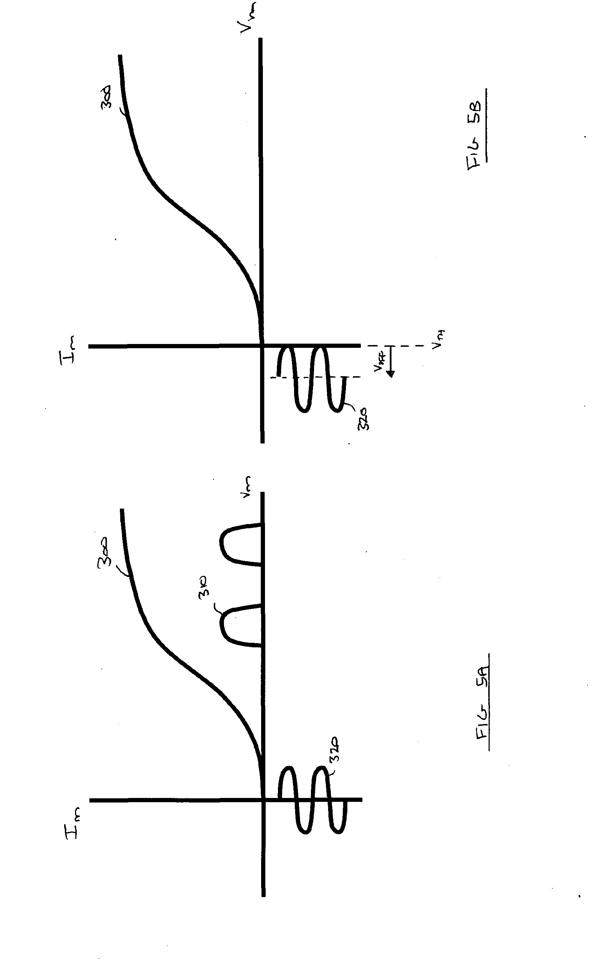

The envelope bias control logic 200 operates to apply a DC offset to the signal input to the peaking power amplifiers 10B, 10C, as illustrated diagrammatically in Figures 5A and 5B. As shown in Figures 5A and 5B, the peaking power amplifiers 10B, 10C have a transfer characteristic 300. As the voltage of the input signal 320 provided to these power amplifiers varies, a half-wave output voltage 310 is output by the peaking power amplifiers 10B, 10C. The envelope bias control logic 200 operates to apply a DC offset V_{off} such that no output signal 310 is provided for input signals 320 having an amplitude less than the threshold V_{TH} as shown in Figure 5B.

As the amplitude of the input signal 320 exceeds the threshold V_{TH}, the offset V_{off} applied to the input signal 320 is reduces until, when operating at a maximum input, no offset V_{off} at all is applied, as shown in Figure 5a.

This approach enables the peaking amplifiers 10B, 10C to operate in Class C at, for example, a 6dB power back off with gradual bias voltage increases according to the signal envelope to provide Class AB operation at maximum power, in the same way as the carrier amplifiers 10A, 10D.

Accordingly, it can be see that through the provision of the offset line and the quadrature couplers, in combination with the quarter wave components, a high efficiency parallel amplifier can be provided which can readily be implemented in integrated circuit form whether hybrid or monolithic. This provides an amplifier arrangement suitable for high efficiency base station power amplifiers, particularly in active antenna array applications. Also it will be appreciated that high efficiency can be achieved at any output power level.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A parallel amplifier, comprising:
a plurality of amplifier modules each operable to receive an input signal, each amplifier module being switchable between an amplifying state and a non-amplifying state to vary a power of an amplified output signal provided by said parallel amplifier, each amplifier module comprising:
an amplifier and an offset line arrangement, said offset line arrangement being operable to compensate for output reactance of said amplifier in said non-amplifying state.

2. The parallel amplifier of claim 1, wherein parasitic components of said amplifier cause said output reactance and said offset line arrangement is operable to substantially cancel said output reactance in said non-amplifying state.

3. The parallel amplifier of claim 1 or 2, wherein said offset line arrangement presents a substantially infinite impedance at an output of said amplifier module in said non-amplifying state.

4. The parallel amplifier of any preceding claim, comprising:
amplifier module control logic operable to switch at least one of said plurality of amplifier modules to said non-amplifying state in dependence on an amplitude of said input signal.

5. The parallel amplifier of claim 4, wherein said plurality of amplifier modules are arranged in pairs and said amplifier module control logic is operable to switch one of each pair of amplifier modules to said non-amplifying state when said amplitude of said input signal fails to achieve a predetermined threshold level.

6. The parallel amplifier of claim 4, wherein said plurality of amplifier modules are arranged in pairs and said amplifier module control logic is operable to switch all except one amplifier module to said non-amplifying state when said amplitude of said input signal fails to achieve a predetermined threshold level.

7. The parallel amplifier of any one of claims 4 to 6, wherein said amplifier module control logic is operable to apply a bias adjustment to amplifier modules in said non-amplifying state to prevent those amplifier modules from providing an amplified signal.

8. The parallel amplifier of any one of claims 4 to 7, wherein said amplifier module control logic is operable to apply said bias adjustment to amplifier modules in said non-amplifying state to prevent those amplifier modules from providing said amplified signal when said input signal has an amplitude at or below said predetermined threshold level.

9. The parallel amplifier of any one of claims 4 to 8, wherein said amplifier module control logic is operable to reduce said bias adjustment when said input signal has an amplitude at or above said predetermined threshold level.

10. The parallel amplifier of any one of claims 4 to 9, wherein said amplifier module control logic is operable to remove said bias adjustment when said input signal has a maximum amplitude.

11. The parallel amplifier of any preceding claim, comprising:
an output network operable to combine amplified signals output by amplifier modules, said output network comprising a plurality of quarter-wave transmission lines each operable to receive an amplified signal output by one of said plurality of amplifier modules, said plurality of quarter-wave transmission lines being arranged in parallel with an output to provide said amplified output signal.

12. The parallel amplifier of any one of claims 1 to 10, comprising:
an output network operable to combine amplified signals output by pairs of amplifier modules, said output network comprising a plurality of quarter-wave transmission lines each operable to receive an amplified signal output by one of said pairs of amplifier modules, said plurality of quarter-wave transmission lines being arranged in parallel with an output to provide said amplified output signal.

13. The parallel amplifier of any preceding claim, comprising:
an input network operable to distribute said input signal to each of said plurality of amplifier modules, said input network comprising a quadrature coupler arrangement.
